# EUROPEAN PATENT APPLICATION

(11) **EP 4 428 294 A2**
(43) Date of publication of application: **11.09.2024**
(21) Application number: 24185573.3
(22) Date of filing: 29.06.2022
(51) Int. Cl.: D06M 14/26

(54) **A METHOD FOR PREPARATION OF VIRUCIDAL POLYMER TEXTILE MATERIALS AND VIRUCIDAL FACE MASKS MADE FROM SAID MATERIALS**

(62) Divisional of application: 22182070.7
(71) Applicant: Jozef Stefan Institute, 1000 Ljubljana (SI); National Institute of Biology, 1000 Ljubljana (SI)
(72) Inventor: Primc, Gregor, Ljubljana (SI); Mozetic, Miran, Ljubljana (SI); Zver, Mark, Ljubljana (SI); Zaplotnik, Rok, Ljubljana (SI); Vesel, Alenka, Ljubljana (SI); Filipic, Arijana, Ljubljana (SI); Dobnik, David, Ljubljana (SI); Kogovsek, Polona, Ljubljana (SI); Ravnikar, Maja, Ljubljana (SI)
(74) Representative: Patentni Biro AF d.o.o.

(57) **Abstract**

The present invention relates to methods for the treatment of textiles used for facial masks. The textiles treated according to the methods of invention ensure for inactivation of viruses captured by the textile. The method for preparation of virucidal polymer textile materials, comprising the following steps:
a) textile material pre-treatment using non-equilibrium gaseous plasma at a pressure below 1000 Pa, wherein the gaseous plasma comprising at least 5 vol% oxygen or water vapor with the fluence of reactive particles, in particular neutral oxygen atoms or OH radicals, between 3×10²² m⁻² and 3×10²⁵ m⁻²,
b) treatment of the pre-treated material obtained in step a) with a diluted solution of a virucidal substance, wherein the virucidal substance is a water solution of a virucidal agent with a concentration in the range from 0.05 to 15% (w/w), and
c) drying the material treated in step b) at a temperature below 100 °C.

## Description

### Field of the invention

The present invention belongs to the field of medicine and protective equipment, more precisely to the field of protective respiratory masks and manufacturing methods thereof. It also belongs to the field of methods for the treatment of various materials, particularly textiles. The invention relates to a method for the preparation of virucidal polymer textiles materials and virucidal face masks made from said materials.

### Background of the invention and the technical problem

Various materials, especially textiles for medical and hygienic use, are being developed with the aim of improving protection against microorganisms. A face mask is an item of protective equipment that primarily guards the airways, wherein surgical masks and cloth face masks may provide protection against the spread of microorganisms and diseases caused by pathogenic microbes. These masks made from textiles are known to capture particles. The particles passing through the textiles may adhere to the textile surface and remain there. The adhesion of small particles is difficult to achieve because many such small particles go past the fibers if the porosity of the textile is large enough to ensure normal breathing. Respiratory viruses are usually found in aerosols, i.e., small droplets of water. A reasonable porosity of the mask textile will ensure for capturing of droplets and, thus, the viruses in the droplets.

The adsorption of viruses on untreated textiles, however, does not inactivate viruses. According to scientific literature, respiratory viruses remain active on the surface of various materials for hours or even days. A review on the virus survival rates on the surface of various materials was, for example, published by Tharayil et al. (Interface Focus 12: 20210042, https://doi.org/10.1098/rsfs.2021.0042).

Therefore, there is a need to develop procedures for manufacturing masks that not only assure virus capturing but also inactivation. The technical problem, which is solved by the present invention, is thus the preparation of suitably treated materials that will efficiently inactivate microbes, particularly viruses. The aim of the invention is also to increase the shelf time of masks compared to standard masks, which is limited to a few hours.

Numerous virucidal substances have been known for decades. They include metals (silver, copper), quaternary ammonium compounds, N-halamines, alcohols, natural polymers (chitosan), oxidants (hydrogen peroxide), etc.

Sodium (dodecyl) sulphate or SDS is an amphiphilic anionic surfactant commonly used as an emulsifying agent in household cleaning products, shampoos, cosmetics, and personal care products. Its solubility in water at room temperature is around 150 g/L. It is highly virucidal in water solutions at various concentrations. Soaking of textiles made from woven or non-woven textiles will assure rapid inactivation of viruses but is impractical because SDS is an irritant at concentrations above 10% and acutely toxic if consumed at 1.3% (w/w). The soaking of textiles with a diluted water solution of SDS cannot be achieved due to the moderate hydrophobicity of textiles. The water droplets containing SDS will remain on the textile surface, so they will not penetrate the space between the textile fibers due to the hydrophobicity of as-synthesized textiles. Hence, improved methods for incorporating virucidal compounds into materials are needed.

### Prior art

A variety of techniques for improving the virucidal properties of masks made from textiles have been disclosed.

Patent application WO2021229444 discloses face mask materials with inherent virucidal activity. The face masks comprise a super-hydrophobic outer layer, a hydrophilic inner layer, and a middle layer having virucidal properties. All three layers are woven and biodegradable. The virucidal properties of the middle layer are achieved by titanium dioxide or zinc oxide nanoparticles attached to the fabrics. The super-hydrophobic properties of the outer layer are achieved by self-assembled steric acid molecules.

Patent application WO2007120509 discloses a virucidal mask that comprises a number of individual layers. Each of these layers is treated with a compound designed to destroy viruses and germs, thus retarding the passage of viruses and germs to the next layer and ultimately to the user. In one embodiment, a layer of acidic material and a separate layer of alkaline material are utilized in a form suitable to be placed over the user's nose and mouth. In one example, a microfibril cloth is soaked in 30% citric acid and allowed to dry. The soaking is repeated several times until 10 grams of dry citric acid has been adsorbed. In another embodiment, sodium lauryl sulphate is applied. In yet another, zinc citrate dihydrate is applied to the fabrics.

Patent EP1785167B1 describes an adsorptive filtering material with biological and chemical protective function, in particular with protective function with regard to both chemical and biological poisons, such as chemical and biological warfare agents, the adsorptive filtering material having a multi-layered construction comprising a first outer supporting layer and a second outer supporting layer and an adsorptive layer disposed between the two supporting layers, the adsorptive filtering material further comprising at least one catalytically active component. The catalytically active component is based on a metal or a metal compound, in particular from the group consisting of copper, silver, cadmium, platinum, palladium, rhodium, zinc, mercury, titanium, zirconium and/or aluminium and also their ions and/or salts, preferably copper and silver and also their ions and/or salts. The adsorptive layer comprises or consists of activated carbon, in particular, present in the form of activated carbon fibers and/or activated carbon particles, preferably in granule form or spherical form.

IN202011017740 discloses a mask with a plurality of layers. The antimicrobial mask is designed in a built pocket in a two-layer mask, wherein the antimicrobial efficiency is provided by Fe₃O₄ nanoparticles, which have been functionalized with starch, polyethylene glycol or SDS.

Patent application WO2022074667A1 discloses a mask that should neutralize the activity of a virus. It is composed of two non-woven fabrics and two melt-blown materials. At least one of the layers is soaked with a water solution that comprises numerous chemicals. A method for the preparation of such a water solution is disclosed as well.

IN202021016559 discloses a substrate treated with a virucidal substance, an adhesive polymer, solvents, and, optionally, other excipients. The virucidal substance may comprise anionic surfactants such as sodium lauryl sulphate, or a variety of acids.

Patent application US2018055968 disclosed a method for permanent hydrophilization of polymeric fibers. The methods include a standard pre-treatment with oxygen plasma and subsequent deposition of a thin polymer film, the thin polymer film forming a shell made from glycated polymers, and a surfactant. This method differs from the present invention in the compounds used to form the film on the treated fibers.

WO2012/130117 discloses mask structure, wherein at least one layer is made hydrophilic and includes an anti-pathogenic material. The hydrophilic layer is made by dipping fabrics into an aqueous solution of water-soluble polymers and numerous other chemicals, including organic acids, salts, surfactants, cross-linking agents, and/or germicidal agents. No pre-treatment of the textile by reactive species from gaseous plasma is needed because the hydrophilic film deposited from the aqueous solution contains surfactants, salts and other chemicals.

Plasma techniques for improved adsorption of virucidal agents, in particular, SDS, were reported in the scientific literature. In 1992, Terlingen et al. used argon plasma for the stabilization of SDS thin film on polypropylene foils. [https://doi.org/10.1006/jcis.1993.1009] The polypropylene films were carefully cleaned in toluene. As-cleaned foils were dipped into the water solution of highly concentrated SDS and carefully dried. The rather large concentration of SDS (24-42 mM) enabled relatively good wetting of the foils by the SDS water solution. The foils with the SDS film were then treated with argon plasma. As a result, the SDS was permanently immobilized on the polypropylene foil. This method differs from the present invention in the sequence of treatment steps, which crucially affects the outcome of treatments of textiles with less concentrated SDS.

SDS was used as a surfactant to deposit a thin film of multiwall carbon nanotubes [https://doi.org/10.31881/TLR.2021.07]. The nanotubes were mixed with the SDS surfactant, and the mixture was sonicated. The cotton fabrics were first treated with plasma and then dipped into the solution of carbon nanotubes in the SDS. The document is silent about the concentration of SDS; however, it is highly likely that the concentration was high (up to 100%) as the nanotubes would fail to disperse in less-concentrated SDS solutions. The SDS-treated carbon nanotubes and the coated fabrics were studied under electron microscopy. The nanotubes were deposited on the surface of the fabrics. The nanotube coatings were found useful as X-ray shielding textiles. No biological testing has been done on the so-prepared fabrics.

Tajima and Komvopoulos (J. Phys. D: Appl. Phys. 39 (2006) 1084-1094) used argon plasma for modification of surface morphology and wettability of polyethylene foils. A variety of morphological features were observed, depending on the fluence of positively charged argon ions. The best wettability was reported at the fluence of positively charged argon ions of about 2×10¹⁵ Jm⁻². The authors are silent about reactive oxygen particles or VUV radiation or virucidal coatings.

### Description of the solution to the technical problem

The main problem in the preparation of virucidal materials is that the active agents (substances) have to be diluted due to their toxicity. The diluted substances, however, do not soak the textiles and, therefore, fail to properly improve the virucidal properties of the textile. The present invention is defined by the appended independent claim. Preferred embodiments of the invention are defined by the dependent claims.

The textile is, according to the methods of the invention, treated in the following manner:
- textile material activation (i.e. pre-treatment) with a non-equilibrium gaseous plasma at the pressure of up to 1000 Pa, wherein the gas comprises at least 5 vol% oxygen or water vapour,
- application of a diluted virucidal substance to the plasma pre-treated material, preferably by soaking, dipping, spraying, roll-coating and immersing, most preferably by soaking or dipping, wherein the virucidal substance is preferably a water solution with a concentration in the range from 0.05 to 15%, most preferably from 0.3 to 3% (w/w), and
- drying the material with any drying method as long as the temperature is low enough to prevent modification of the material mechanical properties.

The materials suitable for such treatment are woven and non-woven textiles. Said textiles may be made from polyethylene, polypropylene, polyesters, as well as biodegradable polymers like polylactic acid, most preferably polypropylene (PP) and polyethylene terephthalate (PET), which are used for manufacturing face masks used for medical and hygienic purposes.

The term "activation" stands for functionalization of fibers' surface with polar functional groups. The activation, i.e. the pre-treatment is performed by treatment with non-equilibrium gaseous plasma to prevent damage to treated textiles. Various discharges are suitable for sustaining gaseous plasma in either continuous or pulsed mode. In one embodiment, a low-pressure gaseous plasma was found particularly useful for the pre-treatment of textiles, i.e., the functionalization of textile fibers' surface with polar functional groups. Plasma pre-treatment is preferably performed at a pressure below 1000 Pa, and the gaseous plasma comprises at least 5 vol% oxygen or water vapor. For effective pre-treatment, the fluence of reactive particles from oxygen plasma (in particular neutral oxygen atoms or OH radicals) is between 3×10²² m⁻² and 3×10²⁵ m⁻².

The virucidal substance may be any suitable substance, for example, sodium oleate, sodium laureate, sodium dodecyl sulphate, 3-[(3-Cholamidopropyl)dimethylammonio]-1-propanesulfonate hydrate (CHAPS), benzyldimethyldodecylammonium chloride (BMC), Triton X-100, quaternary ammonium, rhamnolipids, saponins, Tween, sodium octyl sulphate, ammonium dodecyl sulphate, etc. Combinations of virucidal substances may also be used, provided that the compounds are compatible. In a preferred embodiment, SDS, BMC, and CHAPS were used as virucidal substances. Preferably, the mass of the virucidal substance on the dried mask textile is about 10 grams of SDS substance per kilogram of dry textile, 6.8 g BMC per kilogram of dry textile, and 122 g CHAPS per kilogram of dry textile. The fibers within the textile are drenched in a solution of a virucidal substance during dipping, spraying, roll-coating and immersing, most preferably by soaking or dipping. The soaking time is not particularly limited, but for practical reasons, it is between 1 and 100 s. It is impossible to uniformly distribute such a small concentration of a virucidal substance on the fibers unless they have been pre-treated before soaking with a water solution of the virucidal substance.

Drying of the treated material is performed by any method, including but not limited to dry-air blowing, infra-red and/or microwave drying, and vacuum drying, wherein the textile is kept at a temperature below 100 °C at all times. Before drying, an optional step of draining can be employed in order to shorten drying times. Draining may be performed in any suitable manner known to a skilled person.

The textiles treated with the above-described method exhibit excellent virucidal properties as proved by the ISO 18184 standard (publication date 2019-06) for the case of phi6 bacteriophage, which is a suitable model (surrogate) for enveloped viruses.

The method can be implemented for the mass treatment of textiles. A device for such treatment comprises at least the following:
- a suspender with a roll of suitable material or textile to be treated,
- a vacuum chamber next to the suspender, wherein the textile roll is led through the vacuum chamber for pre-treatment with gaseous plasma,
- a bath or suitable vessel filled with a suitable solution of the virucidal substance, said bath being arranged for receiving at least a part of the textile roll after pre-treatment,
- an optional draining unit installed downstream of the bath for removing excessive water solution of the virucidal substance,
- a drying unit for drying at least a part of the textile roll.

The thus prepared textiles may be used for manufacturing various medical and hygienic products, however, they are most suitable for use in manufacturing respiratory masks, particularly masks made from woven or non-woven textiles, wherein the textile fibers act as materials for capturing aerosols released by humans at breathing, coughing, and sneezing. Unlike the state of the art, the masks not only capture but also inactivate respiratory viruses. The masks may be multi-layered masks, wherein the textile treated according to the invention is the outermost layer, i.e., the layer that is most distant from the skin of the user.

The invention will be further described based on exemplary embodiments, examples, and figures, which show:
- Figure 1: a schematic of the method according to the invention.
- Figure 2: a schematic of the method of the invention suitable for the treatment of mask textiles in a continuous manner
- Figure 3: the concentration of infective bacteriophage phi6 virus on polypropylene textiles treated according to the methods of invention versus the concentration of SDS in the water solution. The dashed line represents the concentration of virus for untreated textile (control).
- Figure 4: the concentration of the infective virus in the textile treated according to the methods of the invention versus aging time of the virucidal textiles.
- Figure 5: comparison of concentrations of infective bacteriophage phi6 virus on polypropylene textiles treated according to the methods of invention versus selected concentrations of SDS (1%), CHAPS (12.3, 1.23, and 0.12%), and BMC (0.68, 0.068, and 0.0068%) in the water solution. The dashed line represents the concentration of virus for untreated textile (control).

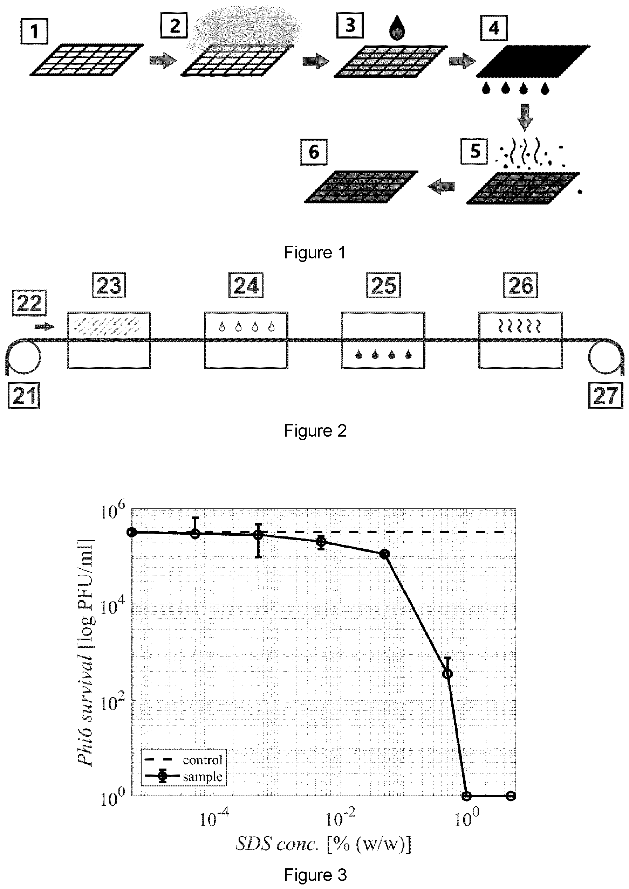

The method for preparation of virucidal materials according to a first embodiment is schematically shown in figure 1 and comprises the following main steps:
a) Material pre-treatment using non-equilibrium gaseous plasma;
b) soaking said plasma-treated material in a diluted water solution of a virucidal substance (preferably SDS), the preferred concentration range of the virucidal substance being from 0.005 to 15% (w/w), for SDS from 0.3 to 3% (w/w), and
c) Drying the material by hanging at room temperature.

The as-produced textile is provided as shown in panel 1, pre-treated with plasma (panel 2), then soaked in the provided diluted water solution of the selected virucidal substance (panel 3), optionally drained (panel 4) to remove excess water, and thereafter dried (panel 5) in order to obtain the textile (panel 6) useful for products for which inactivation of viruses is required, needed or preferred.

In a preferred embodiment, the as-synthesized textile is mounted in a vacuum chamber. The chamber is evacuated to the ultimate pressure, which is, in the preferred embodiment, between 0.1 and 10 Pa. The vacuum chamber at ultimate pressure contains a residual atmosphere, i.e., gases or vapours that remain in the vacuum chamber after achieving the ultimate pressure. The residual atmosphere usually comprises water vapor, while the concentration of other gases or vapours is smaller than the concentration of water vapor. The evacuation of the vacuum chamber is realized using a vacuum pump. The type of the pump is not particularly limited. Once the ultimate pressure has been achieved, gaseous plasma is ignited in the vacuum chamber. Plasma at low pressure is ignited by any discharge, including the direct-current (DC), alternating-current (AC), radio-frequency (RF), and microwave (MW) discharges. The discharge power is not particularly limited, but the best results in terms of rapid pre-treatment of the textiles are achieved at the power density of between 1 and 10 kW per square meter of the textile.

In another embodiment, the vacuum chamber is filled with a reactive gas. The reactive gas could be oxygen, nitrogen, hydrogen, or a noble gas. The pressure of reactive gas is not particularly limited, but the best results are obtained in the range of pressures between about 0.1 and 100 Pa. This pressure range assures uniform plasma in the entire volume of the vacuum chamber. Pure oxygen or oxygen-containing gas like water vapor, hydrogen peroxide vapor, carbon dioxide, sulphur oxides, and nitric oxides were found particularly useful for the pre-treatment of textiles. The as-synthesized textile is placed into the vacuum chamber, which is filled with a reactive gas, plasma is ignited and sustained for an appreciable time to assure appropriate pre-treatment of the textile. The plasma treatment time is not particularly limited, but it is between 0.1 and 100 s in the preferred embodiment.

Once the textile is pre-treated by plasma, it is soaked in a suitably diluted virucidal agent, most preferably in 0.5% (w/w) water solution of sodium dodecyl sulphate (SDS), with sufficient volume to achieve the final concentration of 1% (w/w) of active ingredient per weight of the material, preferably below 1.3%. The soaking time is not particularly limited, but for practical reasons, it is between 1 and 100 s.

After soaking in the diluted solution of the virucidal substance, preferably in the 0.5% (w/w) water solution of SDS, the textile is drained and then dried. Draining is optional and enables the removal of excessive water solution of the virucidal substance. The method for draining is not particularly limited; it could be gentle centrifugation. The (optionally) drained textile is then dried to remove water. The virucidal substance remains on the surface of fibers in the textile after drying. The textile treated according to the methods of the invention is ready for manufacturing of masks.

A method useful for mass treatment of the textiles for masks is shown schematically in Figure 2. The as-synthesized textile is mounted on a roll 21. The textile 22 passes through a vacuum chamber 23, where it is pre-treated with gaseous plasma. The pre-treated textile then passes a bath filled with a liquid solution of the virucidal substance 24 where it is soaked. The soaked textile then passes the draining unit 25 to remove the excessive water solution of the virucidal substance. The drained textile then enters a drying unit 26, where it is dried. The draining unit is optional - it is used in the preferred embodiment to shorten the drying time. Finally, the textile is re-rolled 27 and ready for use in the manufacturing of products, especially face masks.

### Examples

The inactivation of viruses in the textile treated according to the methods of the invention was measured by ISO 18184 - Determination of the antiviral activity of textile products standard.

### Example 1: SDS (sodium dodecyl sulphate) as a virucidal compound

The textile was a commercial material used for surgical masks, i.e., polypropylene. The textile was treated by the methods of the invention and then probed for virus inactivation. The plasma treatment was performed under the following conditions: The residual atmosphere was at a pressure of 4.6 Pa, the plasma treatment time was 10 s, using an electrodeless RF discharge in the E-mode, and the discharge power density was 10 W/cm². In this example, the plasma was sustained in water vapour (water contains 33 at.% oxygen). The fluence of reactive oxygen species was 3×10²³ m⁻² and the fluence of VUV radiation 2×10²¹ m⁻². The concentration of the infective virus in the textile treated according to the methods of the invention, is shown in Figure 3 versus the concentration of SDS in the water solution. The concentration of 1% (w/w) is useful for inactivation of the virus concentration for 7-log. The control samples were tested at identical conditions but without plasma pre-treatment of the textile.

### Example 2: temporal stability of SDS as a virucidal compound on a surgical mask

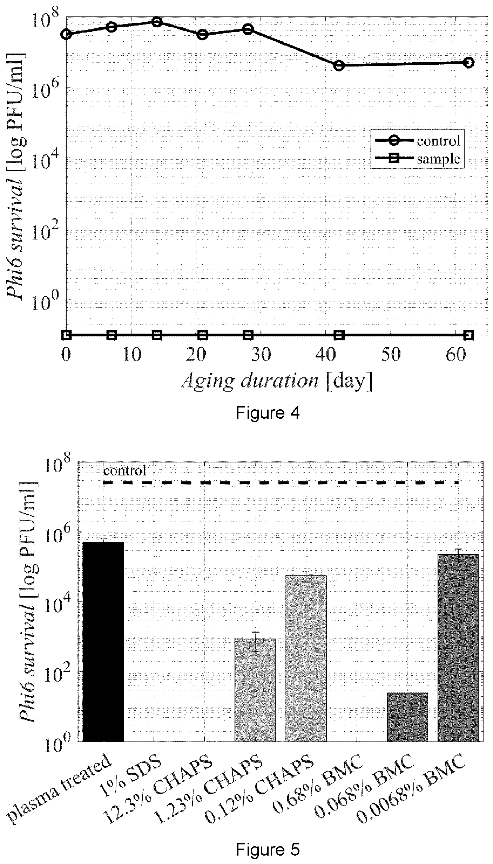

The textile was a commercial material used for surgical masks, i.e., polypropylene. To determine the temporal stability of the virucidal layer, several of the same textiles were treated by the methods of the invention and then probed for virus inactivation immediately after treatment and in specific time frames after treatment. The plasma treatment was performed at the following conditions: The residual atmosphere at the pressure of 4.6 Pa, the plasma treatment time of 10 s, using an electrodeless RF discharge in the E-mode, discharge power density was 10 W/cm². After plasma treatment, the concentration of 1% (w/w) SDS was applied to textiles, which were then dried. The concentration of the infective virus in the textile treated according to the methods of the invention is shown in Figure 4 versus the aging time of the virucidal textiles. The virus was still inactivated up to 7-log even after 62 days of storage of treated materials at ambient conditions.

### Example 3: BMC (benzyldimethyldodecylammonium chloride) as a virucidal compound

The textile was commercial material used for surgical masks, i.e., polypropylene. The textile was treated by the methods of the invention and then probed for virus inactivation. The plasma treatment was performed at the following conditions: The residual atmosphere at the pressure of 4.6 Pa, the plasma treatment time of 10 s, using an electrodeless RF discharge in the E-mode, discharge power density was 10 W/cm². From Figure 5, it can be seen that the concentration of 12.3% (w/w) is useful for inactivation of the virus concentration for 7-log, while lower concentrations, 1.23 and 0.12%, lower the inactivation of the virus concentration to 4-log and 2.5-log, respectively. The control samples were tested at identical conditions but without plasma pre-treatment of the textile.

### Example 4: CHAPS (3-[(3-Cholamidopropyl)dimethylammonio]-1-propanesulfonate hydrate) as a virucidal compound

The textile was commercial material used for surgical masks, i.e., polypropylene. The textile was treated by the methods of the invention and then probed for virus inactivation. The plasma treatment was performed at the following conditions: The residual atmosphere at the pressure of 4.6 Pa, the plasma treatment time of 10 s, using an electrodeless RF discharge in the E-mode, discharge power density was 10 W/cm². The concentration of 0.68% (w/w) is useful for the inactivation of the virus concentration for 7-log, while lower concentrations, 0.068 and 0.0068%, lower the inactivation of the virus concentration to almost 6-log and 2-log, respectively. The control samples were tested at identical conditions but without plasma pre-treatment of the textile.

The absorbing capacity between different layers of a surgical mask is different. The water-diluted sodium dodecyl sulphate (SDS) cannot be absorbed into the outer and the inner layer (made of polypropylene) at below 5.7% (w/w), while SDS cannot absorb into the middle layer (made of polyethylene terephthalate) below 0.5% (w/w).

## Claims

1. A method for preparation of virucidal polymer textile materials, comprising the following steps:
a) Textile material pre-treatment using non-equilibrium gaseous plasma at a pressure below 1000 Pa, wherein the gaseous plasma comprising at least 5 vol% oxygen or water vapor with the fluence of reactive particles, in particular neutral oxygen atoms or OH radicals, between 3×10²² m⁻² and 3×10²⁵ m⁻²,
b) treatment of the pre-treated material obtained in step a) with a diluted solution of a virucidal substance, wherein the virucidal substance is a water solution of a virucidal agent with a concentration in the range from 0.05 to 15% (w/w), and
c) drying the material treated in step b) at a temperature below 100 °C.

2. The method for preparation of virucidal polymer textile materials according to claim 1, wherein a draining step is performed before drying to shorten drying times.

3. The method for preparation of virucidal polymer textile materials according to claim 1 or 2, wherein the drying step assures that the final amount of active substance is 0.05 to 3%, preferably 1%, by weight of the material.

4. The method for preparation of virucidal polymer textile materials according to any of the preceding claims, wherein material treatment with virucidal substance is achieved by soaking, dipping, spraying, roll-coating and immersing, most preferably by soaking or dipping.

5. The method for preparation of virucidal polymer textile materials according to any of the preceding claims, wherein the virucidal substance may be any suitable substance, preferably selected in the group consisting of: sodium dodecyl sulphate (SDS), 3-[(3-Cholamidopropyl)dimethylammonio]-1-propanesulfonate hydrate (CHAPS), benzyldimethyldodecylammonium chloride (BMC); most preferably the virucidal substance is 0.3 to 3% (w/w) SDS.

6. The method for preparation of virucidal polymer textile materials according to any of the preceding claims, wherein the mass of the virucidal substance on the dried mask textile is about 10 grams of virucidal substance per kilogram of dry textile.

7. The method for preparation of virucidal polymer textile materials according to any of the preceding claims, wherein drying in step c) is performed by dry-air blowing, infra-red and/or microwave drying, or vacuum drying.

8. The method for preparation of virucidal polymer textile materials according to any of the preceding claims, wherein the materials are preferably textiles, either woven or non-woven, preferably made from polyethylene, polypropylene, polyesters as well as biodegradable polymers like polylactic acid, most preferably polypropylene (PP) and polyethylene terephthalate (PET).

9. A device for performing the method according to any of the preceding claims, wherein the device comprises at least the following:
- a suspender with a roll of suitable material or textile to be treated,
- a vacuum chamber next to the suspender, wherein the textile roll is led through the vacuum chamber for material activation using non-equilibrium gaseous plasma at a pressure below 1000 Pa, wherein the gaseous plasma comprising at least 5 vol% oxygen or water vapor with the fluence of reactive particles, in particular neutral oxygen atoms or OH radicals, between 3×10²² m⁻² and 3×10²⁵ m⁻²,
- a bath or suitable vessel filled with a suitable solution of the virucidal substance, said bath being arranged for receiving at lefast a part of the textile roll after activation, and wherein the virucidal substance is a water solution of a virucidal agent with a concentration in the range from 0.05 to 15% (w/w),
- an optional draining unit installed downstream of the bath for removing excessive water solution of the virucidal substance,
- a drying unit for drying at least a part of the textile roll at a temperature below 100°C.

10. A medical and/or hygienic product made from materials prepared according to any of the preceding claims.

11. Virucidal medical and/or hygienic products according to the preceding claim, wherein said products are virucidal face masks.

12. Virucidal medical and/or hygienic products according to the preceding claim, wherein the mask comprises the material treated with the method according to any claim from 1 to 10 as the outermost layer, i.e., the layer that is most distant from the skin of the user.
